# EUROPEAN PATENT SPECIFICATION

(11) **EP 3 958 194 B1**
(45) Date of publication and mention of the grant of the patent: **10.01.2024**
(21) Application number: 19929432.3
(22) Date of filing: 23.05.2019
(51) Int. Cl.: G06Q 10/04, G01R 31/62, G06Q 50/06

(54) **METHOD AND DEVICE FOR ASSESSING STATE OF HEALTH OF TRANSFORMER, AND STORAGE MEDIUM**
VERFAHREN UND VORRICHTUNG ZUR BEURTEILUNG DES GESUNDHEITSZUSTANDS EINES TRANSFORMATORS UND SPEICHERMEDIUM
PROCÉDÉ ET DISPOSITIF D'ÉVALUATION DE L'ÉTAT DE SANTÉ D'UN TRANSFORMATEUR, ET SUPPORT DE STOCKAGE

(43) Date of publication of application: 23.02.2022
(73) Proprietor: Siemens Aktiengesellschaft, 80333 München (DE)
(72) Inventor: WANG, Dan, Beijing 100102 (CN); LI, Jing, Beijing 100013 (CN); LIU, Hao, Beijing 100102 (CN); HUA, Wentao, Beijing 100102 (CN); LI, Ang, Beijing 100102 (CN); LIANG, Yue Lin, Edinburgh EH3 9BW (GB); YU, Yong, Hong Kong 999077 (CN)
(74) Representative: Isarpatent
(86) International application number: PCT/CN2019/088191
(87) International publication number: WO 2020/232716

(56) References cited:
- SINGH JASWINDER ET AL: "Distribution Transformer Monitoring for smart grid in India", 2016 IEEE 1ST INTERNATIONAL CONFERENCE ON POWER ELECTRONICS, INTELLIGENT CONTROL AND ENERGY SYSTEMS (ICPEICES), 1 July 2016 (2016-07-01), pages 1-6, XP055964925, DOI: 10.1109/ICPEICES.2016.7853297 ISBN: 978-1-4673-8587-9
- YUE XU ET AL: "Reliability assessment of distribution networks through graph theory, topology similarity and statistical analysis", IET GENERATION, TRANSMISSION&DISTRIBUTION, IET, UK, vol. 13, no. 1, 7 December 2018 (2018-12-07), pages 37-45, XP006104029, ISSN: 1751-8687, DOI: 10.1049/IET-GTD.2018.5520
- DAVARINEJAD EHSAN ET AL: "Fault-Observability Enhancement in Distribution Networks Using Power Quality Monitors", 2018 IEEE ELECTRICAL POWER AND ENERGY CONFERENCE (EPEC), IEEE, 10 October 2018 (2018-10-10), pages 1-6, XP033488866, DOI: 10.1109/EPEC.2018.8598287 [retrieved on 2018-12-31]

## Description

### Technical Field

The present invention relates to the field of electric power systems, in particular to a method and an apparatus for assessing a health status of a transformer, a cloud platform, a server, and a storage medium.

### Background Art

Power quality (PQ) refers to the quality of power in a power system. In a strict sense, main indicators for measuring power quality include voltage, frequency, and waveform. In a general sense, power quality refers to high-quality power supply, including voltage quality, current quality, power supply quality, and power use quality. Power quality problems may be defined as: voltage, current, or frequency deviations that cause electrical equipment to malfunction or operate abnormally, including frequency deviations, voltage deviations, voltage fluctuations and flickers, three-phase imbalance, instantaneous or transient overvoltage, waveform distortions (harmonics), voltage sags, interruptions, and swells, and power supply continuity.

Continuous monitoring, analysis and assessment of power quality information is a precondition for discovering power quality problems and improving power quality. A power quality monitoring system uses a power quality monitoring terminal installed on the power grid side or the user side to transmit monitoring data, namely PQ data, back to a monitoring center (a monitoring master station or sub-station) through a network, thereby simultaneously monitoring a plurality of locations, and releases information related to power quality, providing an effective means of power quality monitoring and assessment.

A transformer is an important part of a power system, and, for example, a distribution transformer refers to a static electrical appliance used in a distribution system to transmit alternating-current power by transforming alternating-current voltages and currents according to the law of electromagnetic induction. It is an apparatus for changing an alternating-current voltage (current) having a certain value into another or a plurality of voltages (currents) of the same frequency with different values. When the primary winding is energized with an alternating current, alternating magnetic flux is produced and, by magnetic permeability of an iron core, induces an alternating electromotive force in the secondary winding. A distribution transformer mainly functions to transmit electrical energy.

On the one hand, PQ data may be used to analyze power quality, and on the other hand, it may be used to analyze a health status of a key electrical apparatus, for example, a transformer. For example, a health status of a transformer is assessable by synthesizing power, voltage, current and harmonic components thereof, and other parameters measured by a power quality monitoring system.

However, not all transformer data may be obtained and used for analysis, due to insufficiency of power quality monitoring systems to record data, and it is neither possible nor practical to monitor each transformer by using power quality monitoring systems, because installation of a power quality monitoring system is expensive and there are usually a large number of transformers even in a small city. Thus, how to access a health status of a transformer configured with no power quality monitoring system has become a problem that needs to be solved urgently.

SINGH JASWINDER ET AL, "Distribution Transformer Monitoring for smart grid in India", 2016 IEEE 1ST INTERNATIONAL CONFERENCE ON POWER ELECTRONICS, INTELLIGENT CONTROL AND ENERGY SYSTEMS(ICPEICES),(20160701), doi:10.1109/ICPEICES.2016.7853297, ISBN 978-1-4673-8587-9, pages 1 - 6, relates to a distribution transformer monitoring approach.

### Summary of the Invention

Against the above-described background, in an embodiment of the present invention, on the one hand, a method for assessing a health status of a transformer is proposed, and on the other hand, an apparatus for assessing a health status of a transformer, a cloud platform, a server, and a storage medium are proposed, in order to assess a health status of a transformer configured with no power quality monitoring system.

According to a first aspect, the invention covers a method for assessing a health status of a transformer proposed in an embodiment of the present invention comprises: using N transformers configured with a power quality monitoring system as a first group of transformers, and obtaining a first measurement dataset of each of the first group of transformers to obtain N first measurement datasets, wherein the first measurement dataset comprises power quality monitoring data, and wherein N is a positive integer greater than or equal to a first specified value; using M transformers configured with no power quality monitoring system as a second group of transformers, and obtaining a second measurement dataset of each of the second group of transformers to obtain M second measurement datasets, wherein M is a positive integer greater than or equal to a second specified value, and the first measurement dataset and the second measurement dataset comprise a common data type; clustering the N transformers in the first group of transformers based on values of the common data type in the N first measurement datasets to obtain r first groups, wherein r is a positive integer; clustering the M transformers in the second group of transformers based on values of the common data type in the M second measurement datasets to obtain r second groups; calculating a similarity between each first group and each second group, and establishing r similarity mapping relationships between the first groups and the second groups based on a maximum similarity between two groups; and assessing a health status of a transformer in each second group using a first measurement dataset of a transformer in a first group that is in a similarity mapping relationship with the second group.

In one embodiment, the first measurement dataset comprises a voltage and/or a current, a harmonic component, and a power of a transformer; and the second measurement dataset comprises at least one of a power, a voltage, and a current of a transformer.

In one embodiment, a collection interval of the common data type in the first measurement dataset is shorter than a collection interval of the common data type in the second measurement dataset.

In one embodiment, the first measurement dataset further comprises at least one of a grid frequency, a voltage deviation, and a voltage interruption.

In one embodiment, M is greater than N.

According to a second aspect, the invention covers an apparatus for assessing a health status of a transformer proposed in an embodiment of the present invention comprises: a first obtaining module configured to use N transformers configured with a power quality monitoring system as a first group of transformers, and obtain a first measurement dataset of each of the first group of transformers to obtain N first measurement datasets, wherein the first measurement dataset comprises power quality monitoring data, and wherein N is a positive integer greater than or equal to a first specified value; a second obtaining module configured to use M transformers configured with no power quality monitoring system as a second group of transformers, and obtain a second measurement dataset of each of the second group of transformers to obtain M second measurement datasets, wherein M is a positive integer greater than or equal to a second specified value, and the first measurement dataset and the second measurement dataset comprise a common data type; a first grouping module configured to cluster the N transformers in the first group of transformers based on values of the common data type in the N first measurement datasets to obtain r first groups, wherein r is a positive integer; a second grouping module configured to cluster the M transformers in the second group of transformers based on values of the common data type in the M second measurement datasets to obtain r second groups; a mapping relationship establishment module configured to calculate a similarity between each first group and each second group, and establish r similarity mapping relationships between the first groups and the second groups based on a maximum similarity between two groups; and an assessing module configured to assess a health status of a transformer in each second group using a first measurement dataset of a transformer in a first group that is in a similarity mapping relationship with the second group.

In one embodiment, the first measurement dataset comprises a voltage and/or a current, a harmonic component, and a power of a transformer; and the second measurement dataset comprises at least one of a power, a voltage, and a current of a transformer.

In one embodiment, the first measurement dataset further comprises at least one of a grid frequency, a voltage deviation, and a voltage interruption.

Another apparatus not claimed is for assessing a health status of a transformer and comprises: at least one memory and at least one processor, wherein the at least one memory is configured to store a computer program; and the at least one processor is configured to invoke the computer program stored in the at least one memory, to perform the method for assessing a health status of a transformer according to any of the above-described embodiments.

A cloud platform or server proposed in an embodiment not claimed comprises the apparatus for assessing a health status of a transformer according to any of the above-described embodiments.

According to a third aspect, the present invention covers a computer-readable storage medium proposed in an embodiment of the present invention stores a computer program; the computer program is executed by a processor to implement the method for assessing a health status of a transformer according to any of the above-described embodiments.

It is thus clear from the above-described solution that, in an embodiment of the present invention, transformers configured with a power quality monitoring system and transformers equipped with no power quality monitoring system are considered as two types of transformers, their respective measurement datasets are obtained, the two types of transformers are clustered and grouped respectively based on a common data type comprised in respective measurement datasets, then similarity mapping relationships are established between groups of the two types of transformers, and then a health status of a transformer configured with no power quality monitoring system is assessed using power quality data on a transformer configured with a power quality monitoring system, which allows an assessment of a health status of a transformer having no power quality monitoring system to be implemented.

In addition, several specific embodiments of data included in several easy-to-implement measurement datasets are described.

Besides, setting a larger M and a larger N allows the two types of transformers to be grouped more accurately when clustered, and thus makes health status assessment more accurate.

### Brief Description of the Drawings

Preferred embodiments of the present invention will be described in detail below with reference to the drawings, allowing those of ordinary skill in the art to have a clearer understanding of the above-described and other features and advantages of the present invention, and among the drawings,
Fig. 1 is an exemplary flowchart of a method for assessing a health status of a transformer in an embodiment of the present invention.
Fig. 2 is an exemplary structural diagram of an apparatus for assessing a health status of a transformer in an embodiment of the present invention.
Fig. 3 is an exemplary structural diagram of another apparatus for assessing a health status of a transformer in an embodiment of the present invention.

The meanings of the reference signs used in the drawings are as follows:

| Reference sign | Meaning |
|---|---|
| S101-S106 | Steps |
| 201 | First obtaining module |
| 202 | Second obtaining module |
| 203 | First grouping module |
| 204 | Second grouping module |
| 205 | Mapping relationship establishment module |
| 206 | Assessing module |
| 31 | Memory |
| 32 | Processor |

### Specific Embodiments

For conciseness and intuitiveness of description, solutions provided by the present invention will be elaborated below by describing several representative embodiments. The great details given in the embodiments are only intended to help understand solutions provided by the present invention. However, it is obvious that the implementation of a technical solution provided by the present invention may not be limited to said details. In order to avoid unnecessary confusion with a solution provided by the present invention, some embodiments are described not in detail, but only structurally. Hereinafter, "comprising" means "including but not limited to", and "based on..." means "at least based on..., but not limited to being only based on...". Due to the linguistic usage pattern of Chinese, when the quantity of an element is not specifically indicated below, it means that the element may number one or more, or may be understood to number at least one.

In an embodiment of the present invention, considering that a large number of transformers are configured with no power quality monitoring system and that some transformers are configured with a power quality monitoring system, the transformers configured with a power quality monitoring system and the transformers configured with no power quality monitoring system may be regarded as two types of transformers; in addition, considering that health statuses of transformers with similar characteristics should be similar, the two types of transformers may be clustered and grouped according to certain characteristics, then similarity mapping relationships may be established between groups of the two types of transformers, and then a health status of a transformer configured with no power quality monitoring system is assessed using power quality data on a transformer configured with a power quality monitoring system.

In order to make clearer the technical solutions and advantages of the present invention, the present invention will be described in greater detail below in conjunction with the drawings and embodiments. It should be understood that the specific embodiments described herein are only intended to illustrate the present invention, instead of limiting the protection scope of the present invention.

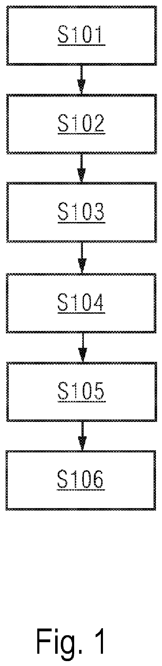

Fig. 1 is an exemplary flowchart of a method for assessing a health status of a transformer in an embodiment of the present invention. As shown in Fig. 1, the method may comprise the following steps:
Step S101: using N transformers configured with a power quality monitoring system as a first group of transformers, and obtaining a first measurement dataset of each of the first group of transformers to obtain N first measurement datasets, wherein N is a positive integer greater than or equal to a first specified value. According to the present invention, the first measurement dataset comprises power quality monitoring data, also called PQ data.

For example, in one embodiment, N first measurement datasets may be denoted by S1={T₁, T₂,...,T_{N}}, where N is the number of transformers, T₁ is the first measurement dataset of the first transformer, T₂ is the first measurement dataset of the second transformer, and Tₙ is the first measurement dataset of the N-th transformer. The value of the first specified value may be an experimental value or an empirical value.

In one embodiment, a first measurement dataset may comprise a voltage and/or current, a harmonic component, a power, etc. of a transformer. In addition, in another embodiment, a first measurement dataset may further comprise at least one of a grid frequency, a voltage deviation, and a voltage interruption.

Step S102: using M transformers configured with no power quality monitoring system as a second group of transformers, and obtaining a second measurement dataset of each of the second group of transformers to obtain M second measurement datasets, wherein M is a positive integer greater than or equal to a second specified value. The first measurement dataset and the second measurement dataset comprise a common data type.

For example, in one embodiment, M second measurement datasets may be denoted by S2={N₁, N₂,...,N_{M}}, where M is the number of transformers, N₁ is the second measurement dataset of the first transformer, N₂ is the second measurement dataset of the second transformer, and Nₘ is the second measurement dataset of the M-th transformer. M is much larger than N in most cases. The value of a second specified value may be an experimental value or an empirical value.

In one embodiment, a second measurement dataset may comprise at least one of a voltage, a current, and a power of a transformer. For example, if the second measurement dataset only comprises a power, then a common data type comprised in the first measurement dataset and the second measurement dataset is power; another example is that, if the second measurement dataset comprises a power and a voltage, and the first measurement dataset also comprises a power and a voltage, then a common data type comprised in the first measurement dataset and the second measurement dataset is power and voltage. Generally, since data on a transformer configured with a power quality monitoring system is collected more frequently, a collection interval of the common data type in the first measurement dataset is shorter than a collection interval of the common data type in the second measurement dataset.

Step S103: clustering the N transformers in the first group of transformers based on values of the common data type in the N first measurement datasets to obtain r first groups, wherein r is a positive integer.

For example, if the common data type comprised in the first measurement dataset and the second measurement dataset is power, then in step S103, the N transformers in the first group of transformers may be clustered based on values of power in the N first measurement datasets to obtain r first groups. For example, they may further be denoted by Al, A2,..., Ar respectively.

Step S104: clustering the M transformers in the second group of transformers based on values of the common data type in the M second measurement datasets to obtain r second groups.

For example, if the common data type comprised in the first measurement dataset and the second measurement dataset is power, then in step S104, the M transformers in the second group of transformers may be clustered based on values of power in the M second measurement datasets to obtain r second groups. For example, they may be denoted by B1, B2, ..., Br.

Step S105: calculating a similarity between each first group and each second group, and establishing r similarity mapping relationships between the first groups and the second groups based on a maximum similarity between two groups.

In this step, a similarity mapping between A1, A2,..., Ar and B1, B2,..., Br, for example, *f*ⱼ:Bᵢ→Aⱼ, may be determined. In specific implementation, a similarity between any two groups of the two is calculable, for example, by representing a similarity value with a number between 0 and 1, 1 indicating the greatest similarity, 0 indicating the least similarity, and then by associating the pairwise groups that have the largest similarity value to obtain r similarity mapping relationships.

Step S106: assessing a health status of a transformer in each second group using a first measurement dataset of a transformer in a first group that is in a similarity mapping relationship with the second group.

For example, for the above-mentioned mapping relationship *f*ⱼ:Bᵢ→Aⱼ, a health status of a transformer in group Bᵢ is assessable using a health state of a transformer in group Aⱼ, that is, being assessable using a first measurement dataset of a transformer in group Aⱼ. In addition, an assessment may also be performed in conjunction with other data, such as location environment and other factors.

After a method for assessing a health status of a transformer in an embodiment of the present invention has been described in detail above, an apparatus for assessing a health status of a transformer in an embodiment of the present invention will be described below, wherein the apparatus in an embodiment of the present invention may be used to implement the above-described method in an embodiment of the present invention, and, for content not disclosed in detail in the apparatus embodiments of the present invention, see the corresponding description of the above-described method embodiments, which will not be described in detail again.

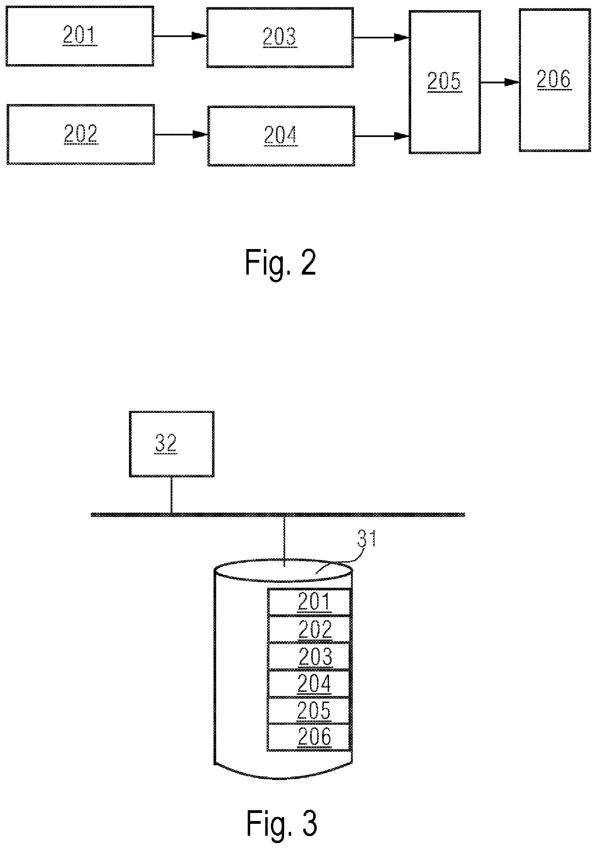

Fig. 2 is an exemplary structural diagram of an apparatus for assessing a health status of a transformer in an embodiment of the present invention. As shown in Fig. 2, the apparatus may comprise: a first obtaining module 201, a second obtaining module 202, a first grouping module 203, a second grouping module 204, a mapping relationship establishment module 205, and an assessing module 206.

The first obtaining module 201 is configured to use N transformers configured with a power quality monitoring system as a first group of transformers, and obtain a first measurement dataset of each of the first group of transformers to obtain N first measurement datasets, wherein N is a positive integer greater than or equal to a first specified value. In one embodiment, the first measurement dataset may comprise a voltage and/or current, a harmonic component, a power, etc. of a transformer; in another embodiment, the first measurement dataset may further comprise at least one of a grid frequency, a voltage deviation, and a voltage interruption.

The second obtaining module 202 is configured to use M transformers configured with no power quality monitoring system as a second group of transformers, and obtain a second measurement dataset of each of the second group of transformers to obtain M second measurement datasets, wherein M is a positive integer greater than or equal to a second specified value, and the first measurement dataset and the second measurement dataset comprise a common data type. In one embodiment, the second measurement dataset comprises at least one of a power, a voltage, and a current of a transformer. In one embodiment, a collection interval of the common data type in the first measurement dataset is shorter than a collection interval of the common data type in the second measurement dataset. In one embodiment, M is greater than N.

The first grouping module 203 is configured to cluster the N transformers in the first group of transformers based on values of the common data type in the N first measurement datasets to obtain r first groups, wherein r is a positive integer.

The second grouping module 204 is configured to cluster the M transformers in the second group of transformers based on values of the common data type in the M second measurement datasets to obtain r second groups.

The mapping relationship establishment module 205 is configured to calculate a similarity between each first group and each second group, and establish r similarity mapping relationships between the first groups and the second groups based on a maximum similarity between two groups.

The assessing module 206 is configured to assess a health status of a transformer in each second group using a first measurement dataset of a transformer in a first group that is in a similarity mapping relationship with the second group.

Fig. 3 is an exemplary structural diagram of another apparatus for assessing a health status of a transformer in an embodiment of the present invention. As shown in Fig. 3, the apparatus may comprise: at least one memory 31 and at least one processor 32. In addition, the apparatus may further comprise some other components, such as a communication port. These components communicate with one another through a bus.

The at least one memory 31 is configured to store a computer program. In one embodiment, the computer program may be understood as comprising the various modules of an apparatus for assessing a health status of a transformer shown in Fig. 2. In addition, the at least one memory 31 may also store an operating system and the like. Operating systems include, but are not limited to, Android operating system, Symbian operating system, Windows operating system, and Linux operating system.

At least one processor 32 is configured to invoke the computer program stored in the at least one memory 31, to perform the method for assessing a health status of a transformer as described in an embodiment of the present invention. The processor 32 may be a CPU, a processing unit/module, an ASIC, a logic module, a programmable gate array, etc. It can receive and send data through the communication port.

In addition, an embodiment of the present invention further provides a server, or a server cluster, or a cloud platform that comprises the above-described apparatus for assessing a health status of a transformer shown in Fig. 2 or Fig. 3.

It should be noted that not all the steps or modules in the above-described flows and structural diagrams are required, and certain steps or modules may be omitted as needed. The sequence of performing steps is not fixed and may be adjusted as needed. The division of modules is only intended for ease of description of the functional division adopted, and, in actual implementation, a module may be implemented by a plurality of modules, while functions of a plurality of modules may also be implemented by the same module, these modules being locatable in the same device or in different devices.

It is understandable that the hardware modules in the above-described embodiments may be implemented mechanically or electronically. For example, a hardware module may comprise a specially designed permanent circuit or logic element, for example, a special processor, an FPGA, or an ASIC, for completing specific operations. A hardware module may further comprise programmable logic or circuitry (for example, a general-purpose processor or any other programmable processor) that is temporarily configured by software to perform specific operations. Whether to implement a hardware module specifically in a mechanical manner or by using a circuit temporarily configured (for example, being configured by software) may be determined on the basis of cost and time considerations.

In addition, an embodiment of the present invention further provides computer software that may be executed on a server or a server cluster or a cloud platform, the computer software being executable by a processor to implement a method for assessing a health status of a transformer as described in an embodiment of the present invention.

In addition, an embodiment of the present invention further provides a computer-readable storage medium on which a computer program is stored, and the computer program may be executed by a processor to implement a method for assessing a health status of a transformer as described in an embodiment of the present invention. Specifically, a system or device equipped with a storage medium may be provided, the storage medium storing software program code for implementing the functions of any of the above-described embodiments, and a computer (for example, a CPU or an MPU) of the system or device is caused to read and execute the program code stored on the storage medium. In addition, by an instruction based on program code, an operating system, etc. operating on a computer may also be caused to complete part or all of the actual operations. It is also possible that functions of any one of the above-described embodiments may be implemented by writing program code read from a storage medium to a memory disposed in an expansion board inserted into a computer or to a memory disposed in an expansion unit connected to a computer, and then by, according to an instruction of program code, causing a CPU, etc. installed on the expansion board or expansion unit to execute part of all of actual operations. Examples of a storage medium for providing program code include floppy disk, hard disk, magneto-optical disk, optical disk (for example, CD-ROM, CD-R, CD-RW, DVD-ROM, DVD-RAM, DVD-RW, or DVD+RW), magnetic tape, non-volatile memory card, and ROM. Optionally, program code may be downloaded from a server computer via a communications network.

It is thus clear from the above-described solution that, in an embodiment of the present invention, transformers configured with a power quality monitoring system and transformers equipped with no power quality monitoring system are considered as two types of transformers, their respective measurement datasets are obtained, the two types of transformers are clustered and grouped respectively based on a common data type comprised in respective measurement datasets, then similarity mapping relationships are established between groups of the two types of transformers, and then a health status of a transformer configured with no power quality monitoring system is assessed using power quality data on a transformer configured with a power quality monitoring system, which allows an assessment of a health status of a transformer having no power quality monitoring system to be implemented.

In addition, several specific embodiments of data included in several easy-to-implement measurement datasets are described.

Besides, setting a larger M and a larger N allows the two types of transformers to be grouped more accurately when clustered, and thus makes health status assessment more accurate.

The above-described embodiments are only preferred embodiments of the present invention, instead of being intended to limit the scope of the present invention.

## Claims

1. A method for assessing a health status of a transformer, comprising:
using (S101) N transformers configured with a power quality monitoring system as a first group of transformers, and obtaining a first measurement dataset of each of the first group of transformers to obtain N first measurement datasets (S101), wherein the first measurement dataset comprises power quality monitoring data, and wherein N is a positive integer greater than or equal to a first specified value;
using (S102) M transformers configured with no power quality monitoring system as a second group of transformers, and obtaining a second measurement dataset of each of the second group of transformers to obtain M second measurement datasets (S102), wherein M is a positive integer greater than or equal to a second specified value, and wherein the first measurement dataset and the second measurement dataset comprise a common data type;
clustering the N transformers in the first group of transformers based on values of the common data type in the N first measurement datasets to obtain r first groups (S103), wherein r is a positive integer;
clustering the M transformers in the second group of transformers based on values of the common data type in the M second measurement datasets to obtain r second groups (S104);
calculating a similarity between each first group and each second group, and establishing r similarity mapping relationships between the first groups and the second groups based on a maximum similarity between two groups (S105); and
assessing a health status of a transformer in each second group using a first measurement dataset of a transformer in a first group that is in a similarity mapping relationship with the second group (S106).

2. The method for assessing a health status of a transformer as claimed in claim 1, wherein the first measurement dataset comprises a voltage and/or a current, a harmonic component, and a power of a transformer; and
the second measurement dataset comprises at least one of a power, a voltage, and a current of a transformer.

3. The method for assessing a health status of a transformer as claimed in claim 2, wherein a collection interval of the common data type in the first measurement dataset is shorter than a collection interval of the common data type in the second measurement dataset.

4. The method for assessing a health status of a transformer as claimed in claim 2, wherein the first measurement dataset further comprises at least one of a grid frequency, a voltage deviation, and a voltage interruption.

5. The method for assessing a health status of a transformer as claimed in any of claims 1 to 4, wherein M is greater than N.

6. An apparatus for assessing a health status of a transformer, comprising:
a first obtaining module (201) configured to use N transformers configured with a power quality monitoring system as a first group of transformers, and obtain a first measurement dataset of each of the first group of transformers to obtain N first measurement datasets, wherein the first measurement dataset comprises power quality monitoring data and wherein N is a positive integer greater than or equal to a first specified value;
a second obtaining module (202) configured to use M transformers configured with no power quality monitoring system as a second group of transformers, and obtain a second measurement dataset of each of the second group of transformers to obtain M second measurement datasets, wherein M is a positive integer greater than or equal to a second specified value, and wherein the first measurement dataset and the second measurement dataset comprise a common data type;
a first grouping module (203) configured to cluster the N transformers in the first group of transformers based on values of the common data type in the N first measurement datasets to obtain r first groups, wherein r is a positive integer;
a second grouping module (204) configured to cluster the M transformers in the second group of transformers based on values of the common data type in the M second measurement datasets to obtain r second groups;
a mapping relationship establishment module (205) configured to calculate a similarity between each first group and each second group, and establish r similarity mapping relationships between the first groups and the second groups based on a maximum similarity between two groups; and
an assessing module (206) configured to assess a health status of a transformer in each second group using a first measurement dataset of a transformer in a first group that is in a similarity mapping relationship with the second group.

7. The apparatus for assessing a health status of a transformer as claimed in claim 6, wherein the first measurement dataset comprises a voltage and/or a current, a harmonic component, and a power of a transformer; and
the second measurement dataset comprises at least one of a power, a voltage, and a current of a transformer.

8. The apparatus for assessing a health status of a transformer as claimed in claim 7, wherein the first measurement dataset further comprises at least one of a grid frequency, a voltage deviation, and a voltage interruption.

9. A cloud platform or a server, comprising the apparatus for assessing a health status of a transformer as claimed in any of claims 6 to 8.

10. A computer readable storage medium storing a computer program, wherein the computer program is executed by a processor to implement the method for assessing a health status of a transformer as claimed in any of claims 1 to 5.

## Patentansprüche

1. Verfahren zur Beurteilung des Gesundheitszustands eines Transformators, das Folgendes umfasst:
Verwenden (S101) von N Transformatoren, die mit einem Leistungsqualitäts-Überwachungssystem konfiguriert sind, als eine erste Gruppe von Transformatoren, und Erhalten eines ersten Messdatensatzes von jedem der ersten Gruppe von Transformatoren, um N erste Messdatensätze (S101) zu erhalten, wobei der erste Messdatensatz Leistungsqualitäts-Überwachungsdaten umfasst, und wobei N eine positive ganze Zahl größer oder gleich einem ersten spezifizierten Wert ist;
Verwenden (S102) von M Transformatoren, die mit keinem Leistungsqualitäts-Überwachungssystem konfiguriert sind, als eine zweite Gruppe von Transformatoren, und Erhalten eines zweiten Messdatensatzes von jedem der zweiten Gruppe von Transformatoren, um M zweite Messdatensätze (S102) zu erhalten, wobei M eine positive ganze Zahl größer oder gleich einem zweiten spezifizierten Wert ist, und wobei der erste Messdatensatz und der zweite Messdatensatz einen gemeinsamen Datentyp umfassen;
Clustern der N Transformatoren in der ersten Gruppe von Transformatoren basierend auf Werten des gemeinsamen Datentyps in den N ersten Messdatensätzen, um r erste Gruppen zu erhalten (S103), wobei r eine positive ganze Zahl ist;
Clustern der M Transformatoren in der zweiten Gruppe von Transformatoren auf der Grundlage von Werten des gemeinsamen Datentyps in den M zweiten Messdatensätzen, um r zweite Gruppen zu erhalten (S104);
Berechnen einer Ähnlichkeit zwischen jeder ersten Gruppe und jeder zweiten Gruppe und Erstellen von Ähnlichkeits-Zuordnungsbeziehungen zwischen den ersten Gruppen und den zweiten Gruppen basierend auf einer maximalen Ähnlichkeit zwischen zwei Gruppen (S105); und
Beurteilen eines Gesundheitszustands eines Transformators in jeder zweiten Gruppe unter Verwendung eines ersten Messdatensatzes eines Transformators in einer ersten Gruppe, die in einer Ähnlichkeits-Zuordnungsbeziehung zu der zweiten Gruppe steht (S106).

2. Verfahren zur Beurteilung des Gesundheitszustands eines Transformators nach Anspruch 1, wobei der erste Messdatensatz eine Spannung und/oder einen Strom, eine Oberwellenkomponente und eine Leistung eines Transformators umfasst; und
der zweite Messdatensatz mindestens eine Leistung, eine Spannung oder einen Strom eines Transformators umfasst.

3. Verfahren zur Beurteilung des Gesundheitszustands eines Transformators nach Anspruch 2, wobei ein Erfassungsintervall des gemeinsamen Datentyps in dem ersten Messdatensatz kürzer ist als ein Erfassungsintervall des gemeinsamen Datentyps in dem zweiten Messdatensatz.

4. Verfahren zur Beurteilung des Gesundheitszustands eines Transformators nach Anspruch 2, wobei der erste Messdatensatz ferner mindestens eine Netzfrequenz, eine Spannungsabweichung und eine Spannungsunterbrechung umfasst.

5. Verfahren zur Beurteilung des Gesundheitszustands eines Transformators nach einem der Ansprüche 1 bis 4, wobei M größer als N ist.

6. Vorrichtung zur Beurteilung des Gesundheitszustands eines Transformators, die Folgendes umfasst:
ein erstes Beschaffungsmodul (201), das so konfiguriert ist, dass es N Transformatoren, die mit einem Leistungsqualitäts-Überwachungssystem konfiguriert sind, als eine erste Gruppe von Transformatoren verwendet, und einen ersten Messdatensatz von jedem der ersten Gruppe von Transformatoren erhält, um N erste Messdatensätze zu erhalten, wobei der erste Messdatensatz Leistungsqualitäts-Überwachungsdaten umfasst, und
wobei N eine positive ganze Zahl ist, die größer als oder gleich einem ersten spezifizierten Wert ist;
ein zweites Beschaffungsmodul (202), das konfiguriert ist, um M Transformatoren, die mit keinem Leistungsqualitäts-Überwachungssystem konfiguriert sind, als eine zweite Gruppe von Transformatoren zu verwenden und einen zweiten Messdatensatz von jedem der zweiten Gruppe von Transformatoren zu erhalten, um M zweite Messdatensätze zu erhalten, wobei M eine positive ganze Zahl größer oder gleich einem zweiten spezifizierten Wert ist, und wobei der erste Messdatensatz und der zweite Messdatensatz einen gemeinsamen Datentyp umfassen;
ein erstes Gruppierungsmodul (203), das konfiguriert ist, um die N Transformatoren in der ersten Gruppe von Transformatoren auf der Grundlage von Werten des gemeinsamen Datentyps in den N ersten Messdatensätzen zu gruppieren, um r erste Gruppen zu erhalten, wobei r eine positive ganze Zahl ist;
ein zweites Gruppierungsmodul (204), das so konfiguriert ist, dass es die M Transformatoren in der zweiten Gruppe von Transformatoren auf der Grundlage von Werten des gemeinsamen Datentyps in den M zweiten Messdatensätzen gruppiert, um r zweite Gruppen zu erhalten;
ein Zuordnungsbeziehungs-Einrichtungsmodul (205), das so konfiguriert ist, dass es eine Ähnlichkeit zwischen jeder ersten Gruppe und jeder zweiten Gruppe berechnet und Ähnlichkeits-Zuordnungsbeziehungen zwischen den ersten Gruppen und den zweiten Gruppen basierend auf einer maximalen Ähnlichkeit zwischen zwei Gruppen einrichtet; und
ein Beurteilungsmodul (206), das so konfiguriert ist, dass es einen Gesundheitszustand eines Transformators in jeder zweiten Gruppe unter Verwendung eines ersten Messdatensatzes eines Transformators in einer ersten Gruppe, die in einer Ähnlichkeits-Zuordnungsbeziehung zu der zweiten Gruppe steht, beurteilt.

7. Vorrichtung zur Beurteilung des Gesundheitszustands eines Transformators nach Anspruch 6, wobei der erste Messdatensatz eine Spannung und/oder einen Strom, eine Oberwellenkomponente und eine Leistung eines Transformators umfasst; und
der zweite Messdatensatz mindestens eine Leistung, eine Spannung oder einen Strom eines Transformators umfasst.

8. Vorrichtung zur Beurteilung des Gesundheitszustands eines Transformators nach Anspruch 7, wobei der erste Messdatensatz ferner mindestens eine Netzfrequenz, eine Spannungsabweichung und eine Spannungsunterbrechung umfasst.

9. Cloud-Plattform oder Server, umfassend die Vorrichtung zur Beurteilung eines Gesundheitszustands eines Transformators nach einem der Ansprüche 6 bis 8.

10. Computerlesbares Speichermedium, das ein Computerprogramm speichert, wobei das Computerprogramm von einem Prozessor ausgeführt wird, um das Verfahren zur Beurteilung eines Gesundheitszustands eines Transformators nach einem der Ansprüche 1 bis 5 zu implementieren.

## Revendications

1. Procédé d'évaluation d'un état de santé d'un transformateur, comprenant :
l'utilisation (S101) de N transformateurs, configurés avec un système de surveillance de qualité de puissance, comme un premier groupe de transformateurs, et l'obtention d'un premier jeu de données de mesure de chacun du premier groupe de transformateurs afin d'obtenir N premiers jeux de données de mesure (S101), le premier jeu de données de mesure comprenant des données de surveillance de qualité de puissance, et N étant un entier positif supérieur ou égal à une première valeur prescrite ;
l'utilisation (S102) de M transformateurs, configurés sans système de surveillance de qualité de puissance, comme un deuxième groupe de transformateurs, et l'obtention d'un deuxième jeu de données de mesure de chacun du deuxième groupe de transformateurs afin d'obtenir M deuxièmes jeux de données de mesure (S102), M étant un entier positif supérieur ou égal à une deuxième valeur prescrite, et le premier jeu de données de mesure et le deuxième jeu de données de mesure comprenant un type de données commun ;
le regroupement des N transformateurs dans le premier groupe de transformateurs sur la base de valeurs du type de données commun dans les N premiers jeux de données de mesure afin d'obtenir r premiers groupes (S103), r étant un entier positif ;
le regroupement des M transformateurs dans le deuxième groupe de transformateurs sur la base de valeurs du type de données commun dans les M deuxièmes jeux de données de mesure afin d'obtenir r premiers groupes (S104) ;
le calcul d'une similarité entre chaque premier groupe et chaque deuxième groupe, et l'établissement de r relations de correspondance de similarité entre les premiers groupes et les deuxièmes groupes sur la base d'une similarité maximale entre deux groupes (S105) ; et
l'évaluation d'un état de santé d'un transformateur dans chaque deuxième groupe à l'aide d'un premier jeu de données de mesure d'un transformateur dans un premier groupe qui est en relation de correspondance de similarité avec le deuxième groupe (S106).

2. Procédé d'évaluation d'un état de santé d'un transformateur selon la revendication 1, dans lequel le premier jeu de données de mesure comprend une tension et/ou un courant, une composante harmonique, et une puissance d'un transformateur ; et
le deuxième jeu de données de mesure comprend une puissance et/ou une tension et/ou un courant d'un transformateur.

3. Procédé d'évaluation d'un état de santé d'un transformateur selon la revendication 2, dans lequel un intervalle de collecte du type de données commun dans le premier jeu de données de mesure est plus court qu'un intervalle de collecte du type de données commun dans le deuxième jeu de données de mesure.

4. Procédé d'évaluation d'un état de santé d'un transformateur selon la revendication 2, dans lequel le premier jeu de données de mesure comprend en outre une fréquence du réseau et/ou un écart de tension et/ou une coupure de tension.

5. Procédé d'évaluation d'un état de santé d'un transformateur selon l'une quelconque des revendications 1 à 4, dans lequel M est supérieur à N.

6. Appareil d'évaluation d'un état de santé d'un transformateur, comprenant :
un premier module d'obtention (201) configuré pour utiliser N transformateurs, configurés avec un système de surveillance de qualité de puissance, comme un premier groupe de transformateurs, et obtenir un premier jeu de données de mesure de chacun du premier groupe de transformateurs afin d'obtenir N premiers jeux de données de mesure, le premier jeu de données de mesure comprenant des données de surveillance de qualité de puissance et
N étant un entier positif supérieur ou égal à une première valeur prescrite ;
un deuxième module d'obtention (202) configuré pour utiliser M transformateurs, configurés sans système de surveillance de qualité de puissance, comme un deuxième groupe de transformateurs, et obtenir un deuxième jeu de données de mesure de chacun du deuxième groupe de transformateurs afin d'obtenir M deuxièmes jeux de données de mesure, M étant un entier positif supérieur ou égal à une deuxième valeur prescrite, et le premier jeu de données de mesure et le deuxième jeu de données de mesure comprenant un type de données commun ;
un premier module de regroupement (203) configuré pour regrouper les N transformateurs dans le premier groupe de transformateurs sur la base de valeurs du type de données commun dans les N premiers jeux de données de mesure afin d'obtenir r premiers groupes, r étant un entier positif ;
un deuxième module de regroupement (204) configuré pour regrouper les M transformateurs dans le deuxième groupe de transformateurs sur la base de valeurs du type de données commun dans les M deuxièmes jeux de données de mesure afin d'obtenir r deuxièmes groupes ;
un module d'établissement de relations de correspondance (205) configuré pour calculer une similarité entre chaque premier groupe et chaque deuxième groupe, et établir r relations de correspondance de similarité entre les premiers groupes et les deuxièmes groupes sur la base d'une similarité maximale entre deux groupes ; et
un module d'évaluation (206) configuré pour évaluer un état de santé d'un transformateur dans chaque deuxième groupe à l'aide d'un premier jeu de données de mesure d'un transformateur dans un premier groupe qui est en relation de correspondance de similarité avec le deuxième groupe.

7. Appareil d'évaluation d'un état de santé d'un transformateur selon la revendication 6, dans lequel le premier jeu de données de mesure comprend une tension et/ou un courant, une composante harmonique, et une puissance d'un transformateur ; et
le deuxième jeu de données de mesure comprend une puissance et/ou une tension et/ou un courant d'un transformateur.

8. Appareil d'évaluation d'un état de santé d'un transformateur selon la revendication 7, dans lequel le premier jeu de données de mesure comprend en outre une fréquence du réseau et/ou un écart de tension et/ou une coupure de tension.

9. Plateforme dans le cloud ou serveur, comprenant l'appareil d'évaluation d'un état de santé d'un transformateur selon l'une quelconque des revendications 6 à 8.

10. Support de stockage lisible par ordinateur stockant un programme d'ordinateur, le programme d'ordinateur étant exécuté par un processeur pour mettre en œuvre le procédé d'évaluation d'un état de santé d'un transformateur selon l'une quelconque des revendications 1 à 5.
